# EUROPEAN PATENT APPLICATION

(11) **EP 4 718 724 A1**
(43) Date of publication of application: **01.04.2026**
(21) Application number: 25205499.4
(22) Date of filing: 30.09.2025
(51) Int. Cl.: H03K 17/16

(54) **A BIDIRECTIONAL BOOTSTRAPPED SWITCH CIRCUIT**

(30) Priority: 30.09.2024 NL 2038743
(71) Applicant: Nexperia B.V., 6534 AB Nijmegen (NL)
(72) Inventor: van der Velden, Joram Pieter, Delft (NL)
(74) Representative: Pjanovic, Ilija

(57) **Abstract**

A bidirectional bootstrapped switch device, comprising: a switch transistor having a gate, a source, and a drain configured for bidirectional switching between source and drain; and a gate control circuit arranged to provide first and second voltage levels to the gate of the switch transistor in response to a control signal, wherein the first voltage level, applied to the gate in response to a first state of the control signal, being generated by rapidly discharging the gate voltage to a threshold voltage of the switch transistor via a first discharge path, resulting in a high discharge current of the switch transistor, and the second voltage level, applied to the gate in response to a second state of the control signal, being generated by slowly discharging the gate voltage below the threshold voltage of the switch transistor via a second discharge path resulting in a low discharge current of the switch transistor.

## Description

### TECHNICAL FIELD

The present invention generally relates to the field of power electronics, and more particularly to the field of bidirectional bootstrapped switch circuits for example for high-frequency capacitive power converters.

### BACKGROUND OF THE DISCLOSURE

In the field of power electronics, particularly in the design of capacitive power converters, it is essential to have switch devices that can operate efficiently under various voltage and load conditions. One widely used approach in such systems is the bootstrapped switch, which allows the gate of a transistor or other type of switching component, to be raised above the source voltage, enabling the transistor to switch under conditions where source and drain potentials are dynamic and unpredictable. The bootstrapped technique is commonly employed to achieve reliable bidirectional switching in high-frequency applications where the control and switching times are critical. Traditional designs rely on simple gate control circuits to switch the transistors on and off.

However, current implementations face several challenges. One major drawback is that existing switch designs often struggle to balance the need for fast switching with the requirement to manage excessive current transients (dl/dt). When a switch is turned on or off too quickly, the rapid change in current can induce voltage spikes due to inductance in the wiring and internal paths, potentially damaging sensitive components within the integrated circuit. Furthermore, devices in the driver circuit may experience voltage stresses that exceed their designed limits, particularly in systems where the voltage levels can vary widely. These challenges are further intensified by the need to maintain fast switching speeds, especially when operating in the MHz range.

Another limitation of current designs is that they often lack the capability to finely control the gate discharge process during turn-off. For high-frequency applications, the turn-off process needs to be rapid to minimize power losses, but it must also avoid inducing high dl/dt, which can lead to circuit instability. Existing solutions tend to compromise either on switching speed or on current management, leading to inefficiencies, component stress and potential system failures. These limitations prevent current devices from reliably operating at the speeds and under the conditions required for many modern power converter applications.

Accordingly, it is a goal of the present disclosure to provide a bidirectional bootstrapped switch device with a discharge mechanism, which balances the need for fast switching and controlled current transients, thereby overcoming at least some of the above-mentioned disadvantages of the prior art.

### SUMMARY OF THE DISCLOSURE

According one aspect of the present disclosure a bidirectional switch device is provided, which device may be understood as a switch that is capable of controlling the flow of current in either direction between its source and drain terminals. A bootstrapped switch refers to a switching mechanism where the gate voltage of the switch transistor is raised above the source voltage, typically to ensure proper switching when the source voltage is dynamic or when the gate voltage is required to be higher than the supply voltage. The bootstrapped mechanism is commonly used in power converters and other high-frequency applications to improve the efficiency and reliability of the switch operation.

The device comprises a switch transistor or other type of switching means or component with switching capabilities. The switch transistor has a gate, a source, and a drain, which are configured for bidirectional switching between the source and drain. A switch transistor may be understood as an electronic component capable of controlling the flow of current between two terminals, the source and drain, in response to a voltage applied to a third terminal, the gate. In this arrangement, the gate, source, and drain are designed to allow bidirectional current flow, enabling the switch to operate regardless of the direction of the current, which is particularly useful in circuits where the voltage across the switch varies.

The device further comprises a gate control circuit arranged to provide first and second voltage levels to the gate of the switch transistor in response to a control signal. A gate control circuit may be understood as a circuit responsible for regulating the voltage applied to the gate of the transistor, determining whether the transistor is in an on or off state. By providing different voltage levels to the gate in response to a control signal, the gate control circuit manages the switching behavior of the transistor. This allows precise control over the timing and conditions under which the transistor switches on or off, allowing optimizing different speeds of switching while maintaining a controllable dl/dt, which especially in high-frequency applications is critical.

The first voltage level, applied to the gate in response to a first state of the control signal, e.g. a logical state or other state, is generated by rapidly discharging the gate voltage to a threshold voltage of the switch transistor via a first discharge path. A first discharge path may be understood as the route through which charge is removed from the gate, lowering its voltage and switching off the transistor. In this case, the gate voltage is rapidly reduced to the threshold voltage, which is the minimum gate-to-source voltage required to turn the transistor on. An effect of this arrangement is that it enables a fast switching response, necessary for high-frequency operation, where rapid transitions between on and off states are essential to maintaining system performance.

The second voltage level, applied to the gate in response to a second state of the control signal, is generated by slowly discharging the gate voltage around and/or below the threshold voltage of the switch transistor via a second discharge path. A second discharge path refers to an alternative route for removing charge from the gate, but in this case, the discharge occurs more slowly, allowing for a gradual reduction of the gate voltage below the threshold. An effect of this arrangement is that it provides more controlled switching behavior with lowered dl/dt as compared to discharge controlled by the first discharge path, thereby reducing the risk of inducing excessive current transients (dl/dt) during the turn-off process. This is particularly important as inductance in the circuit such as bond wires, should not induce excessive voltages inside the IC, since these uncontrolled transients can cause damage to the circuit.

The device solves the problems addressed by providing a two-stage gate discharge circuit or mechanism, which balances the need for fast switching with controlled current transients. The rapid discharge to the threshold voltage allows for efficient high-frequency operation, while the slower discharge below the threshold ensures that excessive dl/dt is avoided, thereby preventing voltage spikes and stress on the driver circuit. This arrangement enables reliable operation in capacitive power converters, overcoming the limitations of prior art devices that either compromise on switching speed or risk damaging the circuit due to uncontrolled transients.

In an example, the bidirectional bootstrapped switch device comprises a first discharge path with a relatively large transistor having a high width-to-length (W/L) ratio. A width-to-length ratio refers to the ratio between the width and the length of the transistor channel. A larger W/L ratio increases the current-carrying capability of the transistor and reduces its on-resistance. An effect thereof is that it allows for a faster discharge of the gate voltage, ensuring a quick switch-off time when required, which is beneficial in high-frequency applications where speed is a priority.

In an example, the bidirectional bootstrapped switch device comprises a first discharge path wherein the transconductance (gₘ) of the relatively large transistor is higher than that of the second discharge path transistor. Transconductance is a measure of the efficiency with which a transistor converts input voltage changes into output current. A higher transconductance in the first discharge path means the transistor can respond more quickly to changes in gate voltage. An effect thereof is that the discharge process is accelerated, further contributing to the switch's ability to handle high-frequency operations effectively.

In an example, the bidirectional bootstrapped switch device comprises a second discharge path with a relatively small transistor having a lower width-to-length (W/L) ratio compared to the transistor of the first discharge path. A lower W/L ratio results in a transistor with reduced current-carrying capacity and increased on-resistance. An effect thereof is that the gate voltage is discharged more slowly, which provides controlled gate voltage reduction, helping to limit the dl/dt and prevent voltage spikes during the turn-off process.

In an example, the bidirectional bootstrapped switch device comprises a second discharge path comprising a relatively small NMOS transistor, wherein the transconductance (gₘ) of the relatively small transistor is lower than that of the first discharge path transistor. A lower transconductance means the transistor is less sensitive to gate voltage changes, resulting in slower discharge of the gate. An effect thereof is that the slower discharge prevents the excessive generation of transient currents, improving the stability of the circuit during the switch-off operation.

In an example, the bidirectional bootstrapped switch device comprises a first discharge path wherein two or more transistors are arranged in a parallel discharge configuration, preferably in a gate-drain connected configuration, to rapidly discharge the gate voltage to the threshold voltage of the switch transistor. A parallel discharge configuration allows both transistors to conduct simultaneously, effectively reducing the gate voltage more quickly. An effect thereof is that the combined discharge capability of the parallel transistors accelerates the switching process, allowing for faster operation, especially important in high-speed or high-frequency applications.

In an example, the bidirectional bootstrapped switch device comprises a second discharge path wherein two or more transistors are arranged in a series or cascaded discharge configuration, configured to slowly discharge the gate voltage beyond the threshold voltage of the switch transistor. A series or cascaded configuration means that the gate discharge current must pass through all transistors sequentially, providing a more gradual reduction of the gate voltage. An effect thereof is that this arrangement offers finer control over the discharge process, reducing the risk of overvoltage or current surges, thus enhancing the reliability of the device in sensitive circuits.

In an example, the bidirectional bootstrapped switch device comprises a configuration where the transistors in both the first and second discharge paths work in tandem. The discharge current of the two transistors in the first discharge path becomes insignificant once the gate voltage drops below the threshold voltage, as these transistors are gate-drain connected. The transistors in the second discharge path then dominate the total discharge current, gradually taking over the discharge process. An effect thereof is that, as the first path disengages, the second path ensures that the gate voltage is slowly discharged beyond the threshold voltage down to (VG = 0), providing controlled switching that prevents excessive current surges and enhances the stability of the circuit. This dual-path configuration optimizes the balance between fast initial discharge and controlled, slower final discharge.

In an example, the bidirectional bootstrapped switch device comprises a switch transistor selected from the group consisting of an NMOS transistor, a PMOS transistor, a JFET, or an insulated-gate bipolar transistor (IGBT). These different transistor types offer varying performance characteristics such as switching speed, voltage handling, and current capacity. An effect thereof is that the device design can be adapted to different application requirements, whether prioritizing high voltage control, power efficiency, or switching speed.

In an example, the bidirectional bootstrapped switch device comprises first and second discharge paths that are configured to selectively control the gate voltage of the switch transistor based on a control signal. Selectively controlling the discharge paths allows the gate voltage to be adjusted dynamically depending on the system requirements. An effect thereof is that the device can adapt its switching behavior to optimize performance under varying load conditions, ensuring both speed and stability in operation.

In an example, the bidirectional bootstrapped switch device comprises a gate control circuit further comprising a bootstrap capacitor configured to raise the gate voltage above the source voltage. A bootstrap capacitor stores and releases charge to elevate the gate voltage, allowing the switch to handle higher source voltages. An effect thereof is that it enables the switch transistor to remain fully operational even when the source voltage fluctuates, enhancing the range of operating conditions under which the switch can function.

In an example, the bidirectional bootstrapped switch device comprises a gate control circuit wherein the bootstrap capacitor is connected via a switching means to provide the bootstrapped voltage. A switching means allows for selective engagement of the bootstrap capacitor to adjust the gate voltage as needed. An effect thereof is that the device maintains more precise control over the bootstrapped voltage, contributing to more efficient switching and reduced power consumption during operation.

In an example, the bidirectional bootstrapped switch device comprises a gate control circuit with level shifters configured to provide voltage signals to the first and second discharge paths. Level shifters adjust the voltage levels in the control signals to match the operating requirements of the discharge paths. An effect thereof is that the voltage control remains accurate, ensuring that both discharge paths operate correctly under varying voltage conditions.

In an example, the bidirectional bootstrapped switch device comprises a gate control circuit with buffers arranged to drive the transistors in the first and second discharge paths. Buffers provide additional current-driving capability to the control signals, ensuring that the transistors are properly activated. An effect thereof is that the switching process remains reliable, even in high-frequency operations where strong, stable control signals are necessary.

In an example, the bidirectional bootstrapped switch device comprises a switch transistor configured to operate in the MHz frequency range. Operating at such frequencies requires the device to switch on and off very rapidly, which imposes stringent requirements on the control circuit and the transistors. An effect thereof is that the device can be employed in high-speed circuits, such as those used in modern power electronics and communications systems, without sacrificing performance.

In an example, the bidirectional bootstrapped switch device comprises the source and drain of the switch transistor connected to an array of switches for multi-ratio capacitive power conversion. Multi-ratio capacitive power converters adjust the conversion ratio between input and output voltages, and having an array of switches allows for flexible configuration. An effect thereof is that the switch device supports efficient power conversion in complex systems, optimizing both voltage regulation and power efficiency in diverse operating conditions.

### BRIEF DESCRIPTION OF THE DRAWINGS

The disclosure will now be discussed with reference to the drawings, which show in:
Figure 1 depicts a switch device according to an aspect of the present disclosure in the off-state;
Figure 2 depicts a switch device according to an aspect of the present disclosure in the on-state;
Figures 3a and 3b depict a switch device according to an aspect of the present disclosure in the improved off-state, with the first fast discharge path highlighted in bold in figure 3a, and the second slow discharge path highlighted in bold in figure 3b;
Figure 4 depicts the different discharge times trough the different transistors.

### DETAILED DESCRIPTION OF THE DISCLOSURE

For a proper understanding of the disclosure, in the detailed description below corresponding elements or parts of the disclosure will be denoted with identical reference numerals in the drawings.

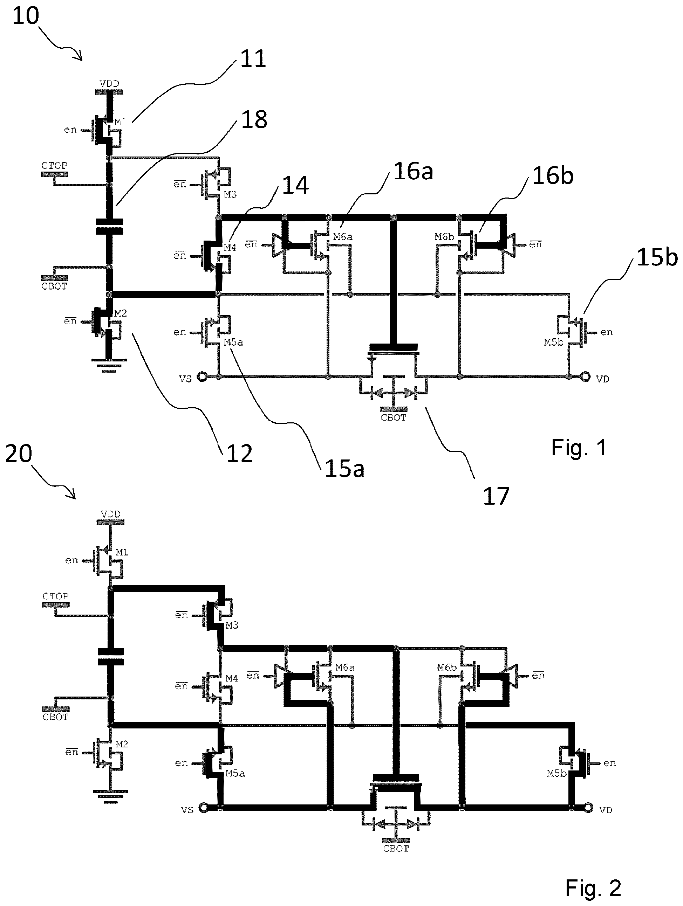

Figure 1 shows provides a schematic view of the bidirectional bootstrapped switch device 10. The device comprises a switch transistor 17 having a gate, source, and drain, configured for bidirectional switching. The switch transistor is connected to a gate control circuit consisting of transistors M2, 12 M4, 14, M6a, 16a and M6b, 16b, which regulate the voltage applied to the gate to control the switching behavior. The gate control circuit is responsible for providing distinct voltage levels to the gate.

Figure 1 depicts the device 10 in an off-state wherein the EN=low, EN(bar)=high and the gate of the switch device 17 is grounded through a series of transistors M2, 12, and M4, denoted with reference number 14. As a result, there is no conduction in the switch device 17. The bulk of the switch device (denoted in the figures with CBOT) is also grounded through the transistors M2, reference number 12. As a result, for any positive VS or VD there is no conduction between VS and VD. The two transistors M6a and M6b, denoted as 16a and 16b have no conduction from VS/VD to GND as their gate is grounded. The bootstrap capacitor 18 is charged up to the VDD through the transistors M1 and M2, denoted with 11 and reference number 12.

Figure 2 depicts the device 20 in an on-state wherein EN=high, EN(bar)=high and the bulk of the switch device is connected to VS and VD via CBOT through transistors M5a and M5b respectively. In case of a voltage difference between VS and VD the bulk diodes become active and ensure that is at most VCBOT = min(VS,VD) + Vdiode. The gate voltage is bootstrapped to VCBOT + VDD through the capacitor, via transistors M5a/M5b and M3. M6a and M6b have no conduction as they are gate-source connected.

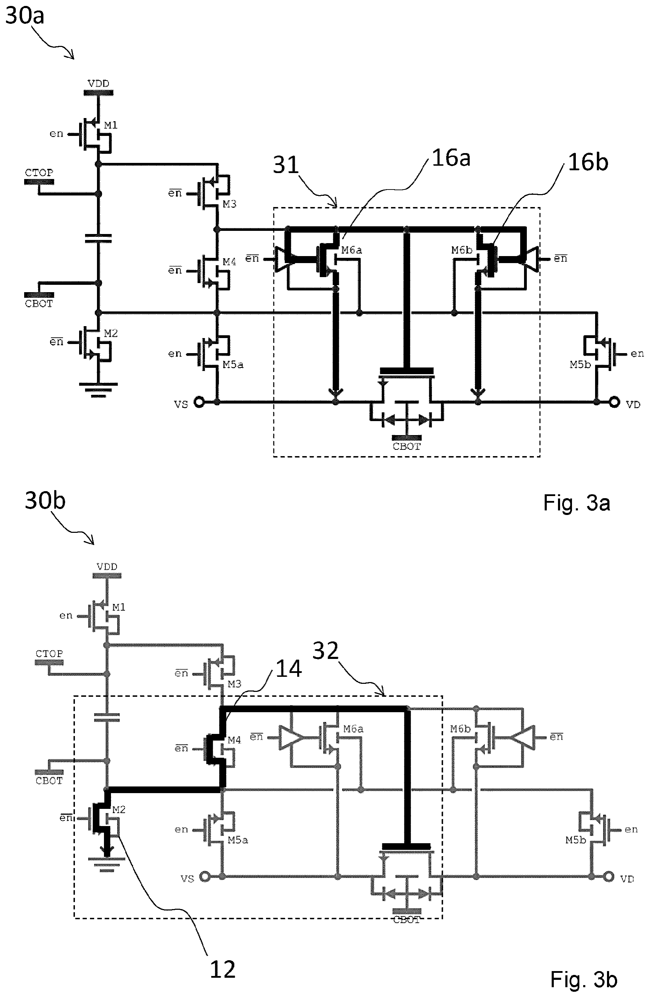

In Figures 3a and 3b the turn-off states are depicted in which the turn-off is improved according to an aspect of the present disclosure. The figures depict the configuration of the two-stage discharge paths in greater detail.

The first discharge path 31, is highlighted in figure 3a, and shows the discharge through the transistors M6a and M6b, with reference numbers 16a and 16b. For VS < VD, M6a discharges the gate down to VG-VS = Vthn and for VD < VS, M6b discharges the gate down to VG-VD = Vthn. The transistors 16a, 16b of this first discharge path 31, are relatively large and arranged in parallel discharge configuration as shown in the figure. This setup ensures that the gate voltage is rapidly discharged to the threshold voltage, as the parallel connection of the transistors increases the discharge current and reduces the on-resistance of the path. The transistors in this path are configured with gate-drain connections, allowing them to efficiently handle fast switching scenarios and to autonomously turn off the discharge path. At a certain moment, the discharge current of M6a and M6b in the first path 31 becomes insignificant once the gate voltage drops below the threshold voltage, as these transistors are gate-drain connected.

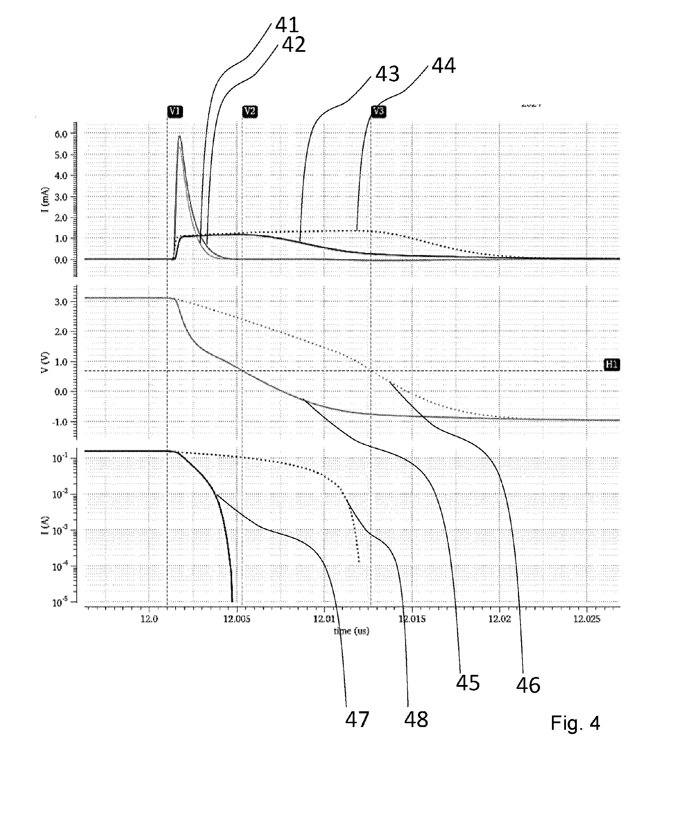

The second discharge path 41 is highlighted in figure 4a, and shows the discharge through the transistors M4 and M2, with reference numbers 14 and 12. Once the discharge current through the first discharge path 31 becomes insignificant, the second discharge path 41 becomes dominant and transistors M2 and M4 dominate the total discharge current. They slowly discharge the gate beyond the threshold voltage down to VG=0. The transistors in this path second discharge path 32 are configured in series or cascaded configuration. This ensures that the gate voltage is gradually reduced beyond the threshold voltage, providing a slower, controlled discharge. The series configuration increases the overall resistance of the path, allowing the current to decrease smoothly, which is essential for managing dl/dt in the switch path and preventing transient voltages. The slow discharge provided by this path is critical for ensuring the stability and reliability of the switch device in capacitive power converters.

The result of this two-stage turn-off is that the turn-off time is mostly determined by the relatively large M6a and M6b devices, whilst the crossing slope near the threshold voltage of the switch device is determined by the relatively small M2/M4, such that a relatively low dl/dt is achieved. Relatively small and large may be understood as transistors with a larger or smaller transconductance (gₘ) or relatively lower or larger width-to-length (W/L) ratio.

In figure 4 the addition of transistors M6a and M6b is shown, which improves the turn-off time while maintaining the same turn-off behaviour around the threshold voltage (in terms of VGS and IDS). In the figure, the drain current of the M6a transistors is depicted with reference number 41, the drain current of the M6b transistor is depicted with reference number 42, the drain current of M4 is depicted in 44 in a switch device of the prior art, as compared to the drain current depicted with 43 in a switch device of the present disclosure. With reference number 45 the gate-source voltage of the main switch device according to the present disclosure is depicted, whereas reference number 46 is that of the prior art. The drain-to-source current of the main switch device according to the present disclosure is depicted with reference number 47, whereas that of the prior art is depicted with reference number 48.

### LIST OF REFERENCE NUMERALS USED

- 10: Bidirectional bootstrapped switch device (in Figure 1).
- 11: Transistor M1.
- 12: Transistor M2.
- 14: Transistor M4.
- 16a: Transistor M6a.
- 16b: Transistor M6b.
- 17: Switch transistor.
- 18: Bootstrap capacitor.
- 20: Bidirectional bootstrapped switch device (in Figure 2, on-state configuration).
- 30a and 30b: Bidirectional bootstrapped switch device (in Figure 3a, in improved off-state).
- 31: First discharge path.
- 41: Second discharge path (also used in Figure 4 to depict the drain current of M6a).
- 42: Drain current of M6b.
- 43: Drain current of the switch device according to the present disclosure.
- 44: Drain current of the switch device according to the prior art.
- 45: Gate-source voltage of the main switch device according to the present disclosure.
- 46: Gate-source voltage of the main switch device according to the prior art.
- 47: Drain-to-source current of the main switch device according to the present disclosure.
- 48: Drain-to-source current of the main switch device according to the prior art.

## Claims

1. A bidirectional bootstrapped switch device, comprising:
a switch transistor having a gate, a source, and a drain configured for bidirectional switching between the source and drain; and
a gate control circuit arranged to provide first and second voltage levels to the gate of the switch transistor in response to a control signal, **characterized by**
the first voltage level, applied to the gate in response to a first state of the control signal, being generated by rapidly discharging the gate voltage to a threshold voltage of the switch transistor via a first discharge path, resulting in a high discharge current of the switch transistor, and
the second voltage level, applied to the gate in response to a second state of the control signal, being generated by slowly discharging the gate voltage below the threshold voltage of the switch transistor via a second discharge path resulting in a low discharge current of the switch transistor.

2. The bidirectional bootstrapped switch device according to claim 1, wherein the first discharge path comprises a relatively large transistor having a high width-to-length (W/L) ratio.

3. The bidirectional bootstrapped switch device according to claim 1 or 2, wherein the first discharge path comprises a relatively large transistor, the transconductance (gₘ) of the relatively large transistor being higher than that of the second discharge path transistor.

4. The bidirectional bootstrapped switch device according to any of the previous claims, wherein the second discharge path comprises a relatively small transistor having a lower width-to-length (W/L) ratio compared to the transistor of the first discharge path.

5. The bidirectional bootstrapped switch device according to any of the previous claims, wherein the second discharge path comprises a relatively small NMOS transistor, the transconductance (gₘ) of the relatively small transistor being lower than that of the first discharge path transistor.

6. The bidirectional bootstrapped switch device according to any of the previous claims, wherein the first discharge path comprises two or more transistors arranged in a parallel discharge configuration, preferably in gate-drain connected configuration, to rapidly discharge the gate voltage to the threshold voltage of the switch transistor.

7. The bidirectional bootstrapped switch device according to any of the previous claims, wherein the second discharge path comprises two or more transistors arranged in a series or cascaded discharge configuration, configured to slowly discharge the gate voltage beyond the threshold voltage of the switch transistor.

8. The bidirectional bootstrapped switch device according to any of the previous claims, wherein the switch transistor is selected from the group consisting of an NMOS transistor, a PMOS transistor, a JFET, or an insulated-gate bipolar transistor (IGBT).

9. The bidirectional bootstrapped switch device according to any of the previous claims, wherein the first and second discharge paths are configured to selectively control the gate voltage of the switch transistor based on a control signal.

10. The bidirectional bootstrapped switch device according to any of the previous claims, wherein the gate control circuit further comprises a bootstrap capacitor configured to raise the gate voltage above the source voltage.

11. The bidirectional bootstrapped switch device according to any of the previous claims, wherein the gate control circuit further comprises a bootstrap capacitor configured to raise the gate voltage above the source voltage and the bootstrap capacitor is connected via a switching means to provide the bootstrapped voltage.

12. The bidirectional bootstrapped switch device according to any of the previous claims, wherein the gate control circuit comprises level shifters configured to provide voltage signals to the first and second discharge paths.

13. The bidirectional bootstrapped switch device according to any of the previous claims, wherein the gate control circuit further comprises buffers arranged to drive the transistors in the first and second discharge paths.

14. The bidirectional bootstrapped switch device according to any of the previous claims, wherein the switch transistor is configured to operate in the MHz frequency range.

15. The bidirectional bootstrapped switch device according to any of the previous claims, wherein the source and drain of the switch transistor are connected to an array of switches for multi-ratio capacitive power conversion.
